# EUROPEAN PATENT SPECIFICATION

(11) **EP 0 467 945 B1**
(45) Date of publication and mention of the grant of the patent: **25.10.1995**
(21) Application number: 90906316.6
(22) Date of filing: 11.04.1990
(51) Int. Cl.: H05K 3/10, H05K 3/46

(54) **PRINTED CIRCUIT BOARDS**
GEDRUCKTE SCHALTUNGSPLATTEN
PLAQUETTES DE CIRCUIT IMPRIME

(30) Priority: 11.04.1989 GB 8908155
(43) Date of publication of application: 29.01.1992
(73) Proprietor: Coates Brothers PLC, Orpington Kent BR5 3PP (GB)
(72) Inventor: IVORY, Nicholas Eric, Glastonbury, Somerset BA6 8AB (GB); COCKETT, Michael Anthony, Lemham, Jent ME17 2QB (GB); WILSON, Derek Edward, Wells, Somerset BA5 3JX (GB)
(74) Representative: Lamb, John Baxter
(86) International application number: GB9000562
(87) International publication number: WO9012482

(56) References cited:
- EP-A- 0 043 458
- EP-A- 0 281 807
- WO-A-89/01282
- DE-B- 1 267 738
- US-A- 4 587 201

## Description

This invention is concerned with improvements and relating to the manufacture of printed circuit boards. Thus, the present invention relates to the manufacture of patterned layers of electrically conductive metals on electrically insulating substrates and is particularly concerned with a method of their manufacture which lends itself to the production of multilevel circuit boards, that is boards having a layered stack of circuits, each insulated from the other but interconnected as and where appropriate.

The use of so-called "resists" in the manufacture of printed circuit boards and the like is well established, and, thus, photo-definable resists are widely used to produce masks for operations such as etching, plating and soldering. Such use is disclosed in WO-A-8901282. The present invention employs photo-definable resists and includes cured resists, at least to some extent, form part of the final product.

Basically the present invention provides a method of making an insulated patterned layer of an electrically conductive metal on a substrate including the steps of forming a patterned relief layer of an electrically insulating resist material upon the substrate, by a photodefinition process comprising the steps of:-
(ii) imagewise exposing the layer of radiation-curable material to radiation to thereby cure portions of the layer exposed to such radiation; and
(iii) removing portions of the layer not exposed to radiation by means of a suitable solvent to thereby produce upon the substrate a patterned layer of cured radiation-curable material.

and then introducing electrically conductive metal into the tracks in the patterned relief layer; forming a thin layer of conductive metal in the tracks by the steps of:
(iv) applying a layer of electrically conductive metal over the surface of the substrate and relief patterned cured material obtained in step (iii) of the photodefinition process;
(v) applying a layer of a radiation-curable material over the surface of the layer of metal deposited in step (iv);
(vi) imagewise exposing the layer of radiation-curable material to radiation in a pattern the negative of that used in step (ii) of the photodefinition process whereby to cure portions of the radiation-curable material exposed to such radiation, but to a lesser extent than the patterned cured material already present on the substrate;
(vii) removing unexposed portions of the radiation-curable material by means of an appropriate solvent to expose portions of the metal layer obtained in step (iv);
(viii) removing the portions of metal exposed in step (vii) by means of an appropriate etchant;
(ix) removing the cured material obtained in step (vi) to thereby expose other portions of metal deposited in step (iv); and
(x) depositing additional electrically conductive metal upon the patterned metal portions exposed in step (ix).

The overall general process of the invention is preferably repeated a number of times to build up a series of layers, one overlying the other. If desired, intermediate layers of photocured resist material may be applied to each of the layers applied as described above and such intermediate layers will generally have through holes (which will be formed by a photodefinition process) appropriately connected to connect the tracks in one layer to those in another. Metal may be introuced into such through holes as and when introducing metal into the tracks in a patterned relief layer immediately above the intermediate layer. Final connections may also be made by applying a layer of metal over the surface of a patterned board.

The first layer of a series of layers of the invention may be formed upon an electrically insulating substrate or may be formed upon a substrate bearing a layer of electrically conductive metal, to facilitate subsequent plating of the tracks in the first patterned relief layer.

In order that the invention may be well understood reference will be made to the accompanying drawings which are simplied schematic cross-sections through boards illustrating various stages in processes according to the invention; Figs. 1(a) - 1(g) illustrate the general process of the invention, and Figures 2(a) - 2(e) and 3(a) - 3(f) illustrating particular processes, not in accordance with the invention, as described in the Examples below.

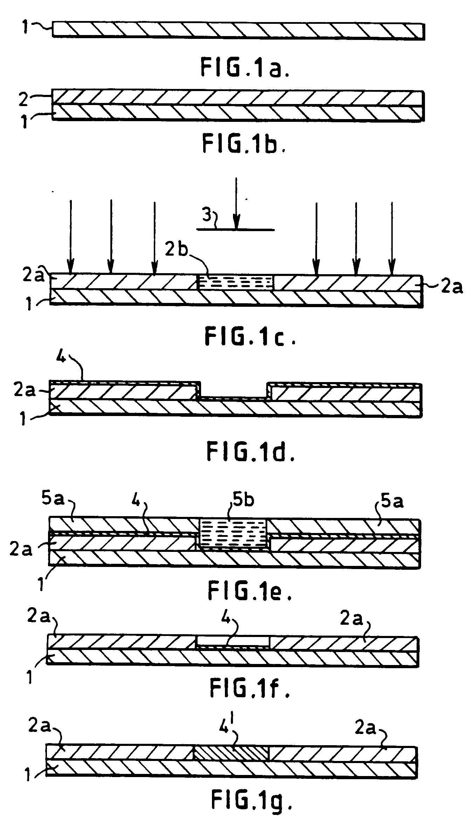

The starting basis for the process illustrated in Figs. 1(a) -1(g) is an insulating substrate, 1 [see Fig. 1(a)]. This will commonly be, as is general in the printed circuit board art, a sheet of reinforced plastics material such a phenolic or epoxy laminate.

In step (i) of the process, there is applied to the insulating substrate, 1, a layer, 2, of a radiation-curable material [see Figure 1 (b)]. The radiation-curable material will, most conveniently, be a UV-curable material and to this extent will contain, as a constituent component, a photo-sensitiser or photoinitiater. Such catalysts are well known in the field of UV-curable compositions and typical examples are dimethoxy phenyl acetophenone, benzophenone and 4,4′-bis(dimethylamine) benzophenone.

The curable component of the curable composition will generally be an ethylenically unsaturated material, especially one containing terminal ethylenically unsaturated groups. A wide variety of materials is known and has been proposed for use in radiation-curable compositions and typical examples thereof include esters of ethylenically unsaturated carboxylic acids (typically acrylic or methacrylic acid) and esters of ethylenically unsaturated alcohols (such as allyl alcohol). Particularly suitable ethylenically unsaturated materials are polyethylenically unsaturated materials obtained by the reaction of ethylenically unsaturated carboxylic acids with saturated materials containing groups reactive with the carboxyl groups of such acids, especially epoxy resins such as epichlorohydrin/Bisphenol A epoxy resins or epoxy Novolak resins. In addition to the ethylenically unsaturated component and UV-photosensitizer the curable compositions may contain other ingredients such as so-called "solder resists" or colouring agents, fillers etc. It is particularly preferred, in accordance with the invention, to use curable compositions containing relatively large amounts of inert fillers, especially those such as are disclosed in our GB-B-2032939 and sold under the trade name "Imagecure". Such compositions comprise unsaturated material, photoinitiator and filler together with a volatile organic solvent and after application to a substrate the solvent is allowed to evaporate off to form a substantially non-tacky film of curable material thereon.

In accordance with an especially preferred embodiment of the invention, the curable composition is one which is developable (see the discussion below) with aqueous alkaline systems and to this end the ethylenically unsaturated material suitably contains free carboxyl groups to permit of solubility in aqueous alkaline solutions. Thus, a particularly preferred form of ethylenically unsaturated material for use in the curable composition is a reaction product of an ethylenically unsaturated carboxylic acid with an epoxy resin, which reaction product has later been modified by reaction with an anhydride of a dicarboxylic acid, to introduce free carboxyl groups into the resultant material.

In step (ii) of the process, substrate 1 bearing the layer of curable material 2 is exposed to radiation (typically UV radiation) as schematically shown in Fig. 1(c) of the drawings. As a result of this irradiation, portions, 2a, of the curable material exposed to the radiation are cured whereas those, 2b, not so exposed remain uncured. It is important that the cured material, 2a, obtained should be more strongly cured or cross-linked than that obtained in subsequent step (vi) and this may be achieved by employing, in step (ii) a higher radiation dose (e.g. a longer period of radiation) than in subsequent step (vi). The degree of cure of the material 2a may also be increased by heating it, e.g. at temperatures of 100 to 150° for periods of 15 to 120 minutes.

In step (iii), the irradiated curable material is "developed", that is the uncured portions 2b, are removed by dissolution with an appropriate solvent. Suitable solvent systems include, for the preferred alkali-developable materials noted above, aqueous alkali solutions such as dilute solutions of sodium hydroxide or sodium carbonate. On the other hand, organic solvent developers may be employed and examples of such suitable solvents include glycol ethers, particularly diethylene glycol monobutyl ether; ketones or aromatic hydrocarbons.

In step (iv), a layer, 4, of electrically conductive metal is applied to the substrate bearing the cured/developed radiation-curable material to give a board as illustrated in Figure 1(d) of the drawings. The metal is most conveniently applied by a vapour deposition method and may be any suitable electrically-conductive metal. Typically, copper will be preferred but, of course, other conductive metals such as aluminium, silver etc. may be employed. The layer 4 may also be formed by a process, as described in US-A-4422108 and US-A-4874477, of firstly depositing a fine layer of carbon black and subsequently electrolytically depositing the desired metal thereon.

The layer of electrically conductive material applied in this step should generally be thin, e.g. from 0.5 to 10, preferably 1 to 5 microns in thickness. In steps (v) and (vi) a further layer of radiation-curable material, 5, is supplied over the surface of the layer of metal, 4, and this is then imagewise exposed to radiation, in a pattern the negative of that used in step (ii); as schematically illustrated in Figure 1(e) of the drawings. As a result irradiated portions of this second layer of photocurable material are cured (but to a lesser extent than the portions, 2a, of the original radiation-curable material) and unirradiated portions are not cured.

In step (vii) the layer, 5a, 5b, of irradiated photo- curable material is developed, in a manner similar to that discussed in connection with step (iii) above. Exposed portions of the metal layer 4 thus revealed, i.e. those originally under unirradiated portions 5a of the second layer, 5, of photo-curable material, are removed with a suitable etchant.

As a result there is obtained a board as schematically illustrated in Figure 1(f) of the drawings, that is one containing a layer of electrically- conductive metal only in those portions, tracks, between the originally formed patterned layer of cured material 2a. In the final step, further electrically conductive material, 4′, is introduced into the portions or tracks between the patterned parts 2a and covering the original layer 4 of electrically conductive material. This additional material may be the same or a different metal from that forming original thin layer 4. The layer 4′ may be formed by any suitable method for forming a layer of an electrically conductive material on an already present patterned layer of electrically conductive metal e.g. by electroplating or, more preferably, by electroless plating. Compositions and methods suitable for electroplating or electroless deposition of electrically conductive metals on thin layers of electrically conductive metals are well known in the printed circuit board art and are described, for example, in "Printed Circuit Handbook", C.F. Coombs, 2nd Edition, McGraw-Hill, 1979.

As shown in Fig. 1(g) the thickness of the conductive layer 4′ is substantially the same as that of the layer of insulating material 2a, formed from the original radiation-curable material. The use of this order of thickness readily facilitates the build-up, repeatingly using the method of the invention, of multilayer or multi-level printed circuit boards; each such subsequent layer being formed by repeating steps (i) - (x) detailed above. Interconnection between successive layers may readily be achieved by appropriate patterning of the tracks 4′ of conductive material in each layer so that, where appropriate, one conductive tract crosses, and connects with, a track in a layer immediately below.

Alternatively, as discussed above, intermediate layers of cured material having appropriately positioned holes may be used to build up multi-level beds using the process of the invention.

The following examples, not in accordance with the invention, are given by way of illustraton only.

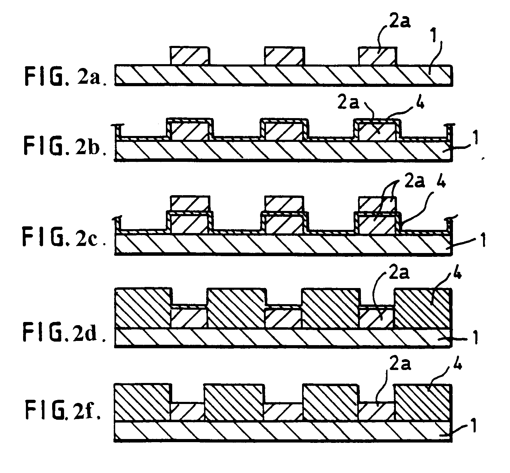

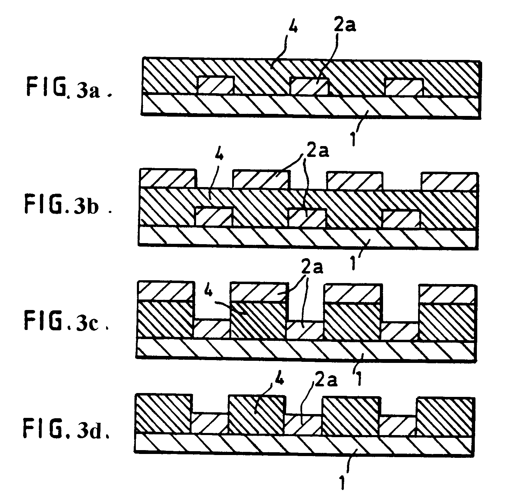

In the examples reference will be made to Figures 2(a) - 2(e) and 3(a) - 3(f) of the drawings. In all these Figures numeral 1 refers to an insulating laminate, numeral 4 refers to copper and numeral 2a to cured resist material.

### Example 1

An SR 4 plain laminate board was coated with Imagecure XV 501 at a dry film thickness of 25 microns. The board was imagewise exposed through a patterned mask so that the resist over the desired circuit patterned remained unharmed. The board was then developed in 0.6% by weight sodium carbonate solution [Fig.2(a)] and the resist layer remaining was then fully heat and UV cured. The board was then plasma etched and given an all-overcoat of metallic copper, 1 micron thick, by vacuum sputtering [Figure 2(b)]. Another layer of resist was then deposited over the metal surface and photoimaged through the mask used to image the previous layer and this was then developed as before [Figure 2(c)]. The board was then pattern electroplated and the resist stripped using 3% by weight sodium hydroxide solution [Figure 2(d)]. The layer of vacuum deposited copper but not built up by the electroplating was then flash etched using acid ferric chloride solution.

### Example 2

The procedure of Example 1 was repeated up to the stage shown in Figure 1(b). A layer of copper (20 microns thick) was then electroplated over the surface of the thin layer of copper. [Figure 2(a)]. A layer of Imagecure XV 501 (about 25 microns dry thickness) was then deposited on to the board and photoimaged through a mask that was the negative of that used in the formation of the initial resist layer. This layer was developed as before [Figure 2(b)] and the copper exposed by this process was then etched away using acid ferric chloride etchant [Figure 2(c)]. The resist over the copper tracks remaining was then stripped away using 3% sodium hyroxide solution [Figure 2(d)].

## Claims

1. A method of making an insulated patterned layer of an electrically conductive metal upon a substrate including the steps of forming a patterned relief layer of an electrically insulating resist material upon the substrate by a photodefinition process comprising the steps of:
(i) applying a layer of a radiation-curable material (2) to the substrate (1);
(ii) imagewise exposing the layer of radiation-curable material to radiation to thereby cure portions (2a) of the layer exposed to such radiation; and
(iii) removing the portions of the layer (2b) not exposed to radiation by means of a suitable solvent to thereby produce upon the substrate a patterned layer of cured radiation-curable material (2a); and
subsequently introducing electrically conductive metal into the depressions (tracks) in the patterned relief layer; wherein the metal is introduced into the tracks by the further steps of:
(iv) applying a layer of electrically conductive metal (4) over the surface of the substrate and relief pattern cured material obtained in step (iii) of the photodefinition process; the method being characterised by the steps of
(v) applying a layer (5a, 5b) of a radiation-curable material (5) over the surface of the layer of metal deposited in step (iv);
(vi) imagewise exposing the layer of radiation-curable material to radiation in a pattern the negative of that used in step (ii) of the photodefinition process whereby to cure portions (5b) of the radiation-curable material exposed to such radiation, but to a lesser extent than the patterned cured material (2a) already present on the substrate;
(vii) removing the unexposed portions (5a) of the radiation- curable material by means of an appropriate solvent to expose portions of the metal layer (4) obtained in step (iv);
(viii) removing the portions of metal exposed in step (vii) by means of an appropriate etchant;
(ix) removing the cured material (5b) obtained in step (vi) to thereby expose other portions of metal deposited in step (iv); and
(x) depositing additional electrically conductive metal (4′) upon the patterned metal portions exposed in step (ix).

## Patentansprüche

1. Verfahren zur Herstellung einer mit Leiterbild eines elektrisch leitfähigen Metalls versehenen Isolierschicht auf einem Substrat, umfassend die Schritte der Erzeugung einer mit Leiterbild versehenen Reliefschicht eines elektrisch isolierenden Resist-Materials auf dem Substrat mit Hilfe eines Photo-Auflösungsprozesses, umfassend die Schritte:
(i) Aufbringen einer Schicht eines strahlungshärtbaren Materials (2) auf das Substrat (1);
(ii) bildpunktweises Exponieren der Schicht des strahlungshärtbaren Materials an Strahlung, um dadurch Abschnitte (2a) der an einer solchen Strahlung exponierten Schicht zu härten; und
(iii) Entfernen der Abschnitte der nicht durch Strahlung exponierten Schicht (2b) mit Hilfe eines geeigneten Lösungsmittels, um dadurch auf dem Substrat eine mit Leiterbild versehene Schicht von gehärtetem strahlungshärtbarem Material (2a) zu erzeugen; sowie
nachfolgendes Einführen von elektrisch leitfähigem Metall in die Vertiefungen (Bahnen) in der mit Leiterbild versehenen Reliefschicht; bei welchem Verfahren das Metall in die Bahnen mit Hilfe der folgenden Schritte eingeführt wird:
(iv) Aufbringen einer Schicht aus elektrisch leitfähigem Metall (4) über der Oberfläche des Substrats und des in Schritt (iii) des Photo-Auflösungsprozesses erhaltenen, mit Leiterbild versehenen und gehärteten Reliefmaterials; welche Methode gekennzeichnet ist durch die Schritte:
(v) Aufbringen einer Schicht (5a, 5b) eines strahlungshärtbaren Materials (5) über der Oberfläche der in Schritt (iv) abgeschiedenen Metallschicht;
(vi) bildpunktweises Exponieren der Schicht des strahlungshärtbaren Materials an Strahlung in einem zu dem in Schritt (ii) des Photo-Auflösungsprozesses negativen Leiterbildes, um dadurch Abschnitte (5b) des an einer solchen Strahlung exponierten strahlungshärtbaren Materials zu härten, jedoch in einem geringeren Maß als das mit Leiterbild versehene gehärtete Material (2a), das bereits auf dem Substrat vorhanden ist;
(vii) Entfernen der nichtexponierten Abschnitte (5a) des strahlungshärtbaren Materials mit Hilfe eines geeigneten Lösungsmittels, um die in Schritt (iv) erhaltenen Abschnitte der Metallschicht (4) zu exponieren;
(viii) Entfernen der Abschnitte des in Schritt (vii) exponierten Metalls, mit Hilfe eines geeigneten Ätzmittels;
(ix) Entfernen des in Schritt (vi) erhaltenen gehärteten Materials (5b), um dadurch andere Abschnitte des in Schritt (iv) abgeschiedenen Metalls zu exponieren; sowie
(x) Abscheiden von zusätzlichem, elektrisch leitfähigem Metall (4′) auf den mit Leiterbild versehenen Metallabschnitten, die in Schritt (ix) exponiert wurden.

## Revendications

1. Procédé de fabrication d'une couche isolée de configuration d'un métal électroconducteur sur un substrat englobant les étapes de formation d'une couche de configuration en relief d'un matériau de réserve à isolement électrique sur le substrat par un procédé de photodéfinition comprenant les étapes ci-dessous:
(i) application d'une couche d'un matériau durcissable par rayonnement (2) sur le substrat (1);
(ii) exposition sous forme d'image de la couche de matériau durcissable par rayonnement au rayonnement pour faire durcir ainsi les parties (2a) de la couche exposées à ce rayonnement; et
(iii) élimination des parties de la couche (2b) non exposées au rayonnement par l'intermédiaire d'un solvant approprié pour produire ainsi sur le substrat une couche de configuration de matériau durcissable par rayonnement durci (2a): et
l'introduction subséquente de métal électroconducteur dans les dépressions (pistes) dans la couche de configuration en relief; dans laquelle le métal est introduit dans les pistes au cours des étapes ultérieures ci-dessous:
(vi) application d'une couche de métal électroconducteur (4) sur la surface du substrat et du matériau durci de configuration en relief produit au cours de l'étape (iii) du procédé de photodéfinition; le procédé étant caractérisé par les étapes ci-dessous:
(v) application d'une couche (5a, 5b) d'un matériau durcissable par rayonnement (5) sur la surface de la couche de métal déposée au cours de l'étape (iv);
(vi) exposition sous forme d'image de la couche de matériau durcissable par rayonnement au rayonnement dans une configuration constituant le négatif de celle utilisée au cours de l'étape (ii) du procédé de photodéfinition, pour faire durcir ainsi les parties (5b) du matériau durcissable par rayonnement exposées à ce rayonnement, mais dans une moindre mesure que le matériau durci de configuration (2a) déjà existant sur le substrat;
(vii) élimination des parties non exposées (5a) du matériau durcissable par rayonnement par l'intermédiaire d'un solvant approprié pour exposer les parties de la couche de métal (4) produite au cours de l'étape (iv);
(viii) élimination des parties de métal exposées au cours de l'étape (vii) par l'intermédiaire d'un agent de gravure approprié;
(ix) élimination du matériau durci (5b) produit au cours de l'étape (vi) pour exposer ainsi d'autres parties de métal déposées au cours de l'étape (iv); et
(x) dépôt de métal électroconducteur additionnel (4′) sur les parties de métal de configuration exposées au cours de l'étape (ix).
